# EUROPEAN PATENT SPECIFICATION

(11) **EP 2 572 561 B1**
(45) Date of publication and mention of the grant of the patent: **20.07.2016**
(21) Application number: 11725894.7
(22) Date of filing: 03.06.2011
(51) Int. Cl.: H05K 3/28, H01L 23/544, H05K 1/18, H05K 3/00, H05K 1/02, H05K 3/32

(54) **METHOD FOR DIVIDING A LARGE SUBSTRATE INTO SMALLER ONES AND METHOD FOR CONTROLLABLY SELECTIVELY DEPOSITING A SEALANT MATERIAL**
VERFAHREN UM EIN BREITES SUBSTRAT IN KLEINERE SUBSTRATE ZU TEILEN UND VERFAHREN UM AUF KONTROLLIERTE WEISE EIN VERSIEGELUNGSMATERIAL SELEKTIV ZU DEPONIEREN
MÉTHODE POUR DIVISER UN SUBSTRAT LARGE EN SUBSTRATS PLUS PETITS ET MÉTHODE POUR DÉPOSER DE FAÇON CONTRÔLÉE UN MATÉRIAU DE SCELLEMENT

(30) Priority: 04.06.2010 GB 201009404
(43) Date of publication of application: 27.03.2013
(73) Proprietor: Flexenable Limited, Milton Road Cambridge Cambridgeshire CB4 0FX (GB)
(72) Inventor: RIEDEL, David, 01309 Dresden (DE); LIEHR, Stefan, 01109 Dresden (DE); CORTEGA-CAGARA, Rina, 01309 Dresden (DE)
(74) Representative: Evans, Marc Nigel
(86) International application number: PCT/EP2011/059215
(87) International publication number: WO 2011/151453

(56) References cited:
- DE-A1- 19 742 837
- DE-A1- 19 742 839
- DE-C1- 19 742 268
- US-A- 5 266 380
- US-A1- 2002 114 507
- US-A1- 2002 185 482
- US-A1- 2006 078 187
- US-A1- 2008 244 901
- US-A1- 2009 314 739

## Description

The present invention relates to a technique for detecting the edge of a substrate in the production of electronic apparatus, such as an electronically-controllable display apparatus.

The production of an electronic consumer apparatus typically involves processing the upper surface of a substrate before removing a perimeter portion of the substrate to create a trimmed substrate, bonding the trimmed substrate to e.g. a tape carrier package (TCP), and creating a seal between the opposing surfaces of the trimmed substrate and the TCP at an edge portion of the trimmed substrate to protect elements located closer to the centre of the trimmed substrate.

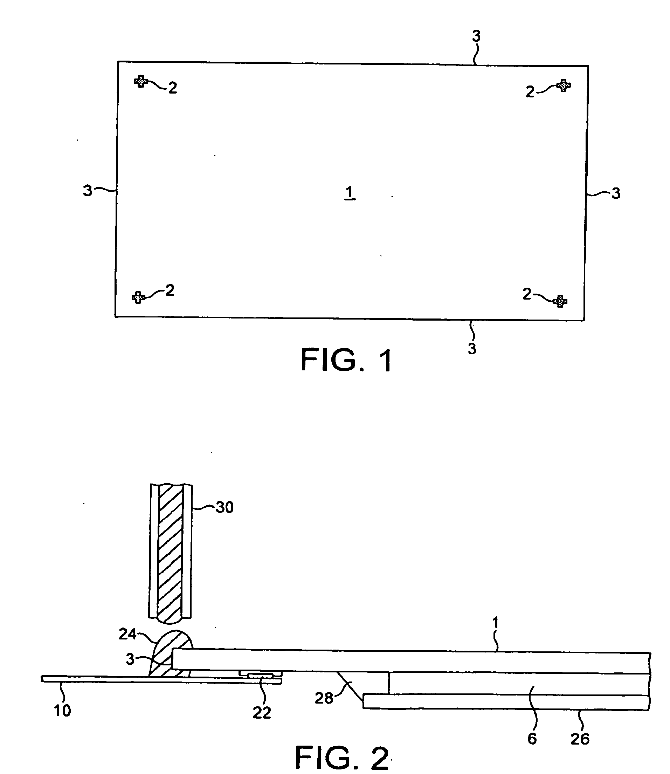

The provision of these seals has been carried out automatically by controlling the location of the deposition of a sealant material with reference to a set of alignment marks of the kind illustrated in Figure 1, which are also used for other steps in the production process.

The inventors have found that the use of such alignment marks can result in the sealant material being deposited other than where it is required.

It is an aim of the present invention to provide an improved technique for automatically depositing sealant material at the edge of a trimmed substrate in the production of electronic apparatus, and to provide a technique for producing a trimmed substrate that facilitates the accurate deposition of sealant material at the edge of the trimmed substrate.

US2006/0078187 describes a technique for cutting an aggregate board to extract multiple electronic components. DE19742268 describes a technique of detecting the positional displacement of multilayer composite structures. US5266380, DE19742839 and DE19742837 describe techniques for visually verifying the proper assembly and alignment of layers of a circuit board. US2009/0314739 describes a technique of spraying a workpiece.

The present invention provides a method according to claim 1.

Hereunder is provided, by way of example only, a detailed description of an embodiment of the present Invention, with reference to the accompanying drawings, in which:
Figure 2 Illustrates the deposition of sealant material to provide a mechanical seal between the edge portion of a trimmed substrate and a tape carrier package;

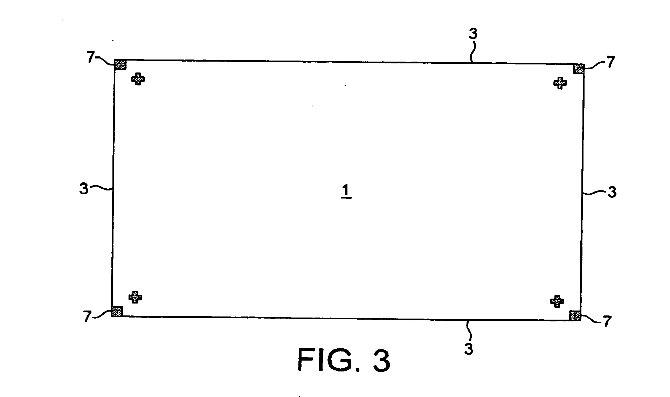

Figure 3 illustrates the provision of detection marks at the corners of a trimmed substrate in accordance with an embodiment of the present Invention;
Figure 4 illustrates an example of the provision of a new kind of detection mark on a corner section of an untrimmed substrate in accordance with an embodiment of the present Invention; and
Figures 5, 6 and 7 show substrates after the trimming process and illustrate how the new detection mark of Figure 4 has a portion aligned with the edges of a corner of a trimmed substrate, even if there is some variation in the substrate trimming process.

Figure 2 illustrates the deposition of resin material 24 to create a mechanical seal between a substrate 1 and a tape carrier package 10. The substrate 1 is optically transparent, and, before the substrate trimming process, has been provided on its front side with an array of electronic transistor devices that function to control the operation of a display medium.

The array of electronic transistor devices and the display medium are generally designated by block 6, and are protected by a top encapsulating layer 26 and an edge seal 28 between the substrate 1 and the top encapsulating layer 26. The top encapsulating layer 26 and the edge seals 28 provide environmental protection for the electronic transistor devices and display medium against humidity and moisture ingress.

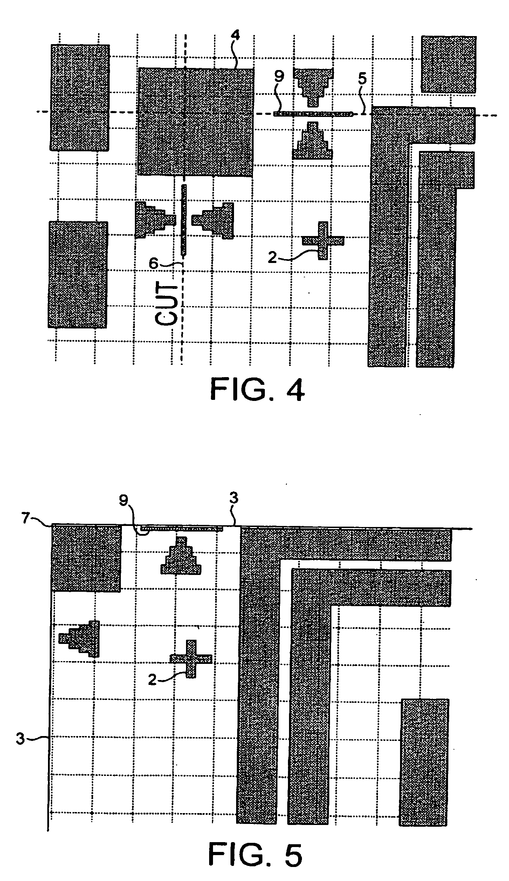

The conductive elements (e.g. electrodes, addressing lines) at one level of the array of electronic transistor devices are defined by a patterned Ti/Au bilayer that is formed on a planarization layer over the substrate 1 by photolithographic and etching processes. As mentioned above, this patterned Ti/Au layer is formed before a perimeter portion of the substrate 1 is trimmed away. The patterned Ti/Au layer also defines marks which have no electronic function in the electronic transistor devices. These marks are illustrated in Figure 4 for one corner section of the untrimmed substrate. The same set of marks is also provided at each of the other corner sections of the untrimmed substrate. The marks include: fiducial crosses 2; cut lines 9 for guiding the process of cutting away an perimeter portion of the substrate 1; and square marks 4, whose function is explained below.

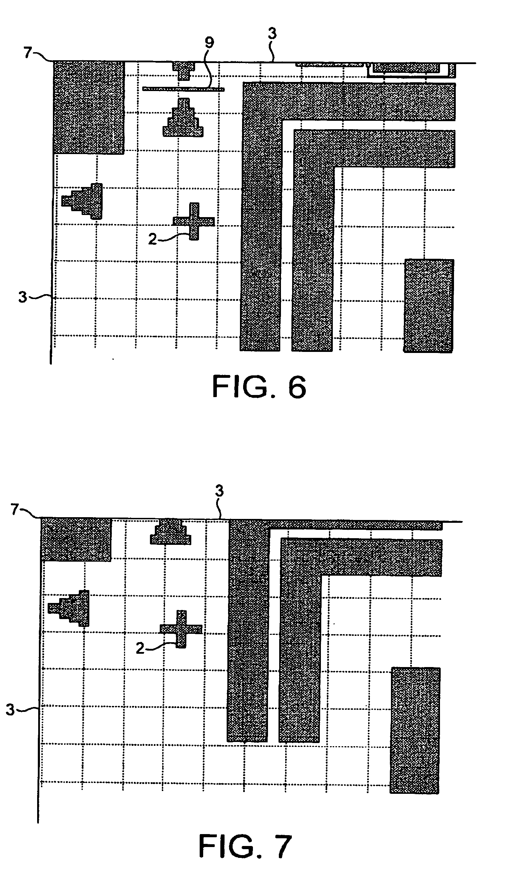

As mentioned above, after the processing of the upper surface of the substrate 1 is completed (i.e. after the formation of the array of electronic transistor devices, display medium, top encapsulating layer 26 and edge seals 28 etc. is completed), a perimeter portion of the substrate 1 is removed by making perpendicular cuts 5, 6, using for example, a laser, blade or water jet. The cutting process uses cut lines 9 as guide marks for the cuts. The nature of the cutting process is such that the actual location of the perpendicular cuts 5, 6 may vary between substrates. For example, the perpendicular cuts 5, 6 may coincide exactly with the cut lines 9 (as shown in Figures 4 and 5), or may deviate somewhat from the cut lines 9 (as shown in Figures 6 and 7) within an acceptable tolerance range.

Each of the square marks 4 mentioned above are sized and located such that wherever the perpendicular cuts 5, 6 are made within said tolerance range, a portion 7 of the square marks (which portion is hereafter referred to as a corner mark) remains at a respective corner of the trimmed substrate 1 with edges that are aligned with the two edges 3 of the trimmed substrate 1 that define the respective corner. Figure 2 illustrates the resulting provision of the above-described corner marks 7 at each of the four corners of the trimmed substrate 1.

The front side of an edge portion of the trimmed substrate 1 is then bonded to a tape carrier package using anisotropic conductive film (ACF) bonds 22. Next, a resin 24 is deposited along the edge 3 of the trimmed substrate 1 so as to provide a mechanical seal between the trimmed substrate 1 and the tape carrier package 10, which mechanical seal serves to protect the ACF bonds 22. The resin deposition process is controlled using the corner marks 7 at the corners of the trimmed substrate as means by which an automatic recognition system identifies the edge 3 of the substrate. An optical detector (not shown) detects the corner marks 7, identifies the edge 3 of the substrate from the outer edges of the corner marks 7, and provides an input to a controller for adjusting the position of a resin deposition needle 30. The optical detector can detect the corner marks 7 from the rear side (backplane) of the trimmed substrate 1 because the substrate 1 is made of an optically transparent material.

The above described technique has the advantage that the precise location of the edges of the trimmed substrate can be detected accurately even if there is some variation in the cutting process and/or some distortion of the substrate during the processing of the substrate.

In order to facilitate the automated process of detecting the corner marks, the following measures are taken: (i) the square marks all have the same shape and size; (ii) the cutting process is designed such that the corner marks 7 all have either a square or rectangular shape, even if there is some variation in their size (this can be achieved by ensuring that the perpendicular cuts are always made at 90 degrees to each other); (iii) no similar shaped marks are provided on the substrate near the square marks that form the corner marks; and (iv) the cutting process is designed such that there is no chipping of the corner marks 7.

We have described an embodiment of the invention for the example of bonding a trimmed substrate to a TCP, but the same embodiment is equally applicable to the bonding of a trimmed substrate to other elements such as chip on film (COF) or flexible printed boards (FPC).

In addition to any modifications explicitly mentioned above, it will be evident to a person skilled in the art that various other modifications of the described embodiment may be made within the scope of the invention.

## Claims

1. A method comprising: forming a plurality of smaller substrates (1) from one or more larger substrates by a reduction process guided by one or more guide marks comprising cut lines (9); **characterised in that**: the reduction process is one according to which there is some possible deviation from the guide marks and some possible variation in size between the smaller substrates within a variation range; and further comprising, in advance of said reduction process, providing said one or more larger substrates with one or more detection marks (4) as part of a patterned layer that also defines said one or more guide marks; wherein the size and the location of the detection marks are selected such that a portion (7) of each detection mark remains as part of the smaller substrate at a corner of said smaller substrate, and has a pair of edges that coincide with at least a part of the pair of edges of the smaller substrate that define said corner, even when the reduction process deviates from the one or more guide marks and whatever the actual size of the smaller substrate within said variation range.

2. A method according to claim 1, comprising forming said detection marks as part of a patterned layer that also defines the conductive elements for one level of an array of electronic devices.

3. A method according to claim 1 or claim 2, comprising controlling the deposition of a sealant material (24) at one or more edges (3) of the smaller substrate on the basis of said one or more detection marks (4).

## Patentansprüche

1. Verfahren, umfassend:
Bilden einer Vielzahl kleinerer Substrate (1) aus einem oder mehreren größeren Substraten durch einen Reduktionsvorgang, der sich an einer oder mehreren Orientierungsmarkierungen orientiert, die Schnittlinien (9) umfassen;
**dadurch gekennzeichnet, dass** : der Reduktionsvorgang einer ist, gemäß dem es einige mögliche Abweichung von den Orientierungsmarkierungen und einige mögliche Variation in der Größe zwischen den kleineren Substraten innerhalb eines Variationsbereichs gibt; und
ferner, vor dem Reduktionsvorgang Vorgang, das Versehen eines oder mehrerer größeren Substrate mit einer oder mehreren Detektionsmarkierungen (4) als Teil einer gemusterten Schicht umfassend, die außerdem die eine oder mehrere Orientierungsmarkierung(en) definiert;
wobei die Größe und die Stelle der Detektionsmarkierungen derart selektiert werden, dass ein Abschnitt (7) jeder Detektionsmarkierung als Teil des kleineren Substrats an einer Ecke des kleineren Substrats verbleibt, und ein Paar von Kanten aufweist, die mit wenigstens einem Teil des Paars von Kanten des kleineren Substrats koinzidieren, welche die Ecke definieren, selbst wenn der Reduktionsvorgang von der einen oder mehreren Orientierungsmarkierungen abweicht und was auch immer die tatsächliche Größe des kleineren Substrates innerhalb des Variationsbereichs ist.

2. Verfahren nach Anspruch 1, welches das Bilden der Detektionsmarkierungen als Teil einer gemusterten Schicht umfasst, die außerdem die leitfähigen Elemente für eine Ebene eines Arrays elektronischer Vorrichtungen definiert.

3. Verfahren nach Anspruch 1 oder Anspruch 2, welches das Steuern der Deponierung eines Versiegelungsmaterials (24) an einer oder mehreren Kanten (3) des kleineren Substrats auf der einen oder mehreren Detektionsmarkierungen (4) beruhend umfasst.

## Revendications

1. Procédé comportant : l'étape consistant à former une pluralité de substrats plus petits (1) à partir d'un ou de plusieurs substrats plus grands par le biais d'un processus de réduction guidé par une ou plusieurs marques de guidage comportant des lignes de coupe (9) ; **caractérisé en ce que** : le processus de réduction est un processus selon lequel il y a un certain écart possible par rapport aux marques de guidage et une certaine variation possible en termes de taille entre les substrats plus petits dans les limites d'une plage de variation ; et comportant par ailleurs, avant ledit processus de réduction, l'étape consistant à fournir auxdits un ou plusieurs substrats plus grands une ou plusieurs marques de détection (4) comme faisant partie d'une couche à motif qui définit aussi lesdites une ou plusieurs marques de guidage ; dans lequel la taille et l'emplacement des marques de détection sont sélectionnés de telle sorte qu'une partie (7) de chaque marque de détection reste comme faisant partie du substrat plus petit au niveau d'un angle dudit substrat plus petit, et a une paire de bords qui coïncident avec au moins une partie de la paire de bords du substrat plus petit qui définissent ledit angle, même quand le processus de réduction s'écarte desdites une ou plusieurs marques de guidage et quelle que soit la taille réelle du substrat plus petit dans les limites de ladite plage de variation.

2. Procédé selon la revendication 1, comportant l'étape consistant à former lesdites marques de détection comme faisant partie d'une couche à motif qui définit aussi les éléments conducteurs pour un niveau d'un réseau de dispositifs électroniques.

3. Procédé selon la revendication 1 ou la revendication 2, comportant l'étape consistant à commander le dépôt d'un matériau de scellement (24) au niveau d'un ou de plusieurs bords (3) du substrat plus petit en fonction desdites une ou plusieurs marques de détection (4).
